# DEMANDE DE BREVET EUROPEEN

(11) **EP 4 842 148 A1**
(43) Date de publication de la demande: **18.11.2026**
(21) Numéro de dépôt: 26174813.1
(22) Date de dépôt: 27.04.2026
(51) Int. Cl.: H05K 3/28

(54) **MODULE ÉLECTRONIQUE COMPORTANT UNE CARTE À CIRCUIT IMPRIMÉ ENROBÉE D'UN MATÉRIAU DE PROTECTION ET ENSEMBLE COMPORTANT UN COMPTEUR DE DÉBIT DE FLUIDE ET UN MODULE ÉLECTRONIQUE**

(30) Priorité: 13.05.2025 FR 2505075
(71) Demandeur: SAGEMCOM ENERGY & TELECOM SAS, 92270 Bois-Colombes (FR)
(72) Inventeur: FAURE, Christophe, 92270 BOIS COLOMBES (FR)
(74) Mandataire: Novagraaf Technologies

(57) **Abrégé**

L'invention propose un module électronique (10) comportant une carte à circuit imprimé (12) qui porte des composants électroniques, électriques ou électromécaniques parmi lesquels au moins une première série de composants qui sont agencés dans une première zone de la carte à circuit imprimé (12) et qui, pour les protéger des influences extérieures nocives, sont noyés dans un matériau de protection qui est coulé sur et autour des composants, et comportant une coque (14) de confinement du matériau de protection autour des composants de la première série qui loge au moins partiellement la carte à circuit imprimé (12) ; qui délimite une cavité interne remplie au moins partiellement du matériau de protection des composants de la première série ; et qui comporte un orifice de coulée du matériau de protection à l'intérieur de la coque de confinement.

L'invention propose aussi un ensemble comportant un compteur de débit d'un fluide sur lequel, ou dans lequel, est installé un module électronique (10) selon l'invention.

## Description

### Domaine technique de l'invention

L'invention concerne le domaine des appareils de mesure du débit d'un fluide, notamment, mais non limitativement, les compteurs d'eau et les compteurs de gaz.

L'invention concerne plus particulièrement un appareil dit « de nouvelle génération » ou encore « intelligent » qui intègre un module électronique permettant par exemple de collecter et de transmettre à distance les résultats des mesures effectuées par un tel appareil.

### Arrière-plan technique de l'invention

Un tel module électronique comporte notamment une carte à circuit imprimé, aussi appelée carte électronique, qui porte des composants électroniques, électriques et / ou électromécaniques.

Pour protéger ces composants des influences extérieures nocives et / ou de conditions climatiques sévères, il est connu de les noyer dans un matériau de protection, couramment appelé « gel », qui est coulé sur et autour de ces composants pour les enrober et les sceller de manière étanche.

Les matériaux de protection tels que les gels d'enrobage constituent une solution de protection permanente qui reste une partie intégrante du module pour protéger les composants.

Qu'il s'agisse d'un compteur de gaz, ou bien encore d'un compteur d'eau, le module électronique peut être agencé à l'intérieur du compteur et notamment dans un fond du boîtier du compteur ou de la cuve du compteur - ou d'un espace creux dédié du boîtier du compteur - de telle manière que la carte à circuit imprimé s'étende horizontalement et la technique de protection des composants évoquée ci-dessus - dite de « potting » - est utilisée pour couler un gel de protection à faible viscosité dans le fond du boîtier du compteur - ou de l'espace creux dédié du boîtier du compteur - pour encapsuler les composants sensibles afin de les protéger.

Le module électronique peut aussi être un élément extérieur rapporté sur une paroi du boîtier du compteur.

Il existe principalement deux techniques de mise en œuvre du potting.

La première - dite de potting complet - consiste à remplir entièrement ou quasi-entièrement l'intérieur du boîtier du compteur, par exemple la cuve du compteur de gaz ; la quantité de gel de protection nécessaire étant alors déterminée par le volume du boîtier du compteur.

La deuxième - dite de potting partiel - consiste à remplir seulement l'espace entre la carte à circuit imprimé et le fond du boîtier du compteur ; la quantité de gel de protection étant alors réduite et correspondant à la quantité nécessaire pour recouvrir la carte à circuit imprimé et l'ensemble des composants agencés sur sa face supérieure que l'on souhaite noyer et protéger.

Durant les opérations de coulée du gel de protection, le gel étant liquide, le niveau haut du gel est une surface horizontale et continue.

Certains composants et / ou fonctions, tels qu'une antenne ou un connecteur qui doivent demeurer en dehors du gel pour être accessibles, sont généralement regroupés sur une deuxième carte à circuit imprimé qui est agencée dans une zone ou région dépourvue de gel de protection, par exemple au-dessus du niveau haut du gel de protection de la première carte à circuit imprimé, et il est alors nécessaire d'utiliser un connecteur inter-cartes pour relier électriquement les deux cartes à circuit imprimé.

D'une manière générale, la technique de potting présente plusieurs inconvénients.

Le volume du matériau de protection utilisé qui peut dépendre du volume complet du boîtier du compteur qu'il est nécessaire de remplir à 100% pour garantir une bonne protection, indépendamment des dimensions de la carte à circuit imprimé, induit un coût important.

Dans le cas d'un ensemble à deux cartes à circuit imprimé avec un connecteur inter-cartes, un tel agencement induit aussi des coûts importants.

Pour réaliser un remplissage complet en matériau de protection, il est nécessaire de réaliser un orifice de remplissage en partie haute du boîtier du compteur et de prévoir de plus un bouchon de fermeture étanche de cet orifice en créant ainsi une source éventuelle de défaut d'étanchéité du boîtier du compteur du compteur.

Après l'opération de potting, il est difficile, voire impossible, d'assurer des réparations de composants sur la partie de la carte à circuit imprimé noyée dans le gel de protection.

Par perméabilité ou par défaut d'étanchéité du boîtier du compteur d'un compteur d'eau, l'eau peut être en contact direct avec le gel de protection et réduire son efficacité protectrice

La mise en œuvre du potting est un procédé contraignant.

Tout d'abord, elle est réalisée dans le compteur une fois que ce dernier est un produit fini, ou quasi-fini, qui est alors un produit encombrant.

De plus, la cadence de potting est impactée par la quantité de compteurs (Que l'on a remplis de gel de protection) que l'on peut mettre dans une étuve à dépression (En vue de réaliser une étape de débullage) qui est nécessairement réduite.

En outre, il peut être nécessaire de nettoyer les compteurs afin d'enlever d'éventuelles traces ou coulées de gel de protection sur la surface extérieure du boîtier du compteur.

La surface nécessaire pour le stockage des compteurs le temps de la polymérisation du gel de protection est importante car elle est liée aux dimensions importantes des compteurs.

S'agissant de la protection par de la résine de tout ou partie des composants montés sur une carte à circuit imprimé d'un module électronique, le document CN117999860A propose une conception faisant appel à une coque de retenue de la résine qui est en une seule pièce et soudée / collée sur une seule face de la carte à circuit imprimé, préalablement aux opérations de coulée.il s'agit d'une conception comportant ainsi de nombreuses étapes complexes avant la coulée. De plus, pour protéger des composants présents sur les deux faces de la carte à circuit imprimé une telle conception nécessite d'effectuer deux opérations successives de coulée, dont la deuxième après réticulation et séchage de la résine coulée en premier lieu.

Le document JPH11307968A propose une conception de principe selon laquelle une enceinte en trois parties distinctes entoure et enferme la carte à circuit imprimé en y délimitant par exemple une zone dépourvue de résine de protection. La coulée de résine dans la ou les zones destinées à recevoir de la résine est complexe car la résine doit être introduite précisément dans les zones concernées et ceci sans aucune solution permettant d'éviter tout risque d'erreur. De plus, la coulée est effectuée à ciel ouvert et la résine risque de refroidir précocement lors des opérations de coulée.

Le document JP2005294703A propose une conception selon laquelle une coque en une seule pièce constitue un étui dans lequel la carte à circuit imprimé est introduite selon une direction parallèle au plan de la carte à circuit imprimé. Une cloison délimite entre eux deux compartiments distincts pouvant être remplis avec des résines différentes. Mais cette conception ne permet pas d'isoler un composant dans un compartiment (rempli de résine) que l'on souhaiterait ne pas noyer dans une résine.

L'invention a notamment pour but de remédier à tout ou partie de ces inconvénients.

### Résumé de l'invention

L'invention propose un module électronique comportant :
- une carte à circuit imprimé qui porte des composants électroniques, électriques ou électromécaniques parmi lesquels au moins une première série de composants qui sont agencés dans une première zone de la carte à circuit imprimé et qui, pour les protéger des influences extérieures nocives, sont noyés dans un matériau de protection qui est coulé sur et autour de ces composants,
- et une coque de confinement du matériau de protection autour desdits composants de la première série :
   - - qui loge au moins partiellement la carte à circuit imprimé ;
   - - qui délimite une cavité interne remplie au moins partiellement du matériau de protection desdits composants de la première série ;
   - - qui entoure la première zone de la carte à circuit imprimé qui est ainsi logée dans une cavité interne ;
   - - et qui comporte un orifice de coulée du matériau de protection à l'intérieur de la coque de confinement,
module électronique dans lequel :
- la carte à circuit imprimé s'étend à l'extérieur de la coque de confinement ;
- une deuxième série de composants sont agencés dans une deuxième zone de la carte à circuit imprimé située à l'extérieur de la coque de confinement ;
- la coque de confinement comporte deux parties complémentaires et opposées assemblées l'une à l'autre, respectivement avant et arrière, dont chacune est agencée en regard d'une face associée, respectivement avant et arrière, des deux faces opposées de la carte à circuit imprimé qui est prise en sandwich entre les deux parties de la coque de confinement,
le module électronique comportant des moyens internes de cloisonnement pour, dans la cavité interne remplie au moins partiellement de matériau de protection, délimiter un espace dans lequel est agencé au moins un composant de la première série et qui ne contient pas de matériau de protection.

Selon d'autres caractéristiques du module électronique :
- la coque de confinement comporte deux parties opposées, respectivement avant et arrière, dont chacune est agencée en regard d'une face associée, respectivement avant et arrière, des deux faces opposées de la carte à circuit imprimé ;
- la cavité interne remplie au moins partiellement de matériau de protection comporte une portion avant délimitée par la partie avant de la coque et par la face avant de la carte à circuit imprimé, et comporte une portion arrière délimitée par la partie arrière de la coque de confinement et par la face arrière de la carte à circuit imprimé ;
- les deux parties opposées de la coque de confinement sont assemblées entre elles par emboîtement élastique d'éléments complémentaires ;
- les deux parties opposées de la coque de confinement sont assemblées entre elles selon une direction orthogonale au plan de la carte à circuit imprimé ;
- la coque de confinement comporte une face externe basse d'appui plan du module électronique sur une surface de travail déterminant une orientation verticale du module électronique lors d'une opération de coulée de matériau de protection à l'intérieur de la coque de confinement, et ledit orifice de coulée est agencé en partie haute de la coque de confinement ;
- ladite face externe basse d'appui plan est orthogonale au plan de la carte à circuit imprimé ;
- la coque de confinement est réalisée en un matériau transparent ou translucide permettant de visualiser la présence éventuelle de bulles dans le matériau de protection.

L'invention propose aussi un ensemble comportant un compteur de débit d'un fluide comportant un boîtier sur lequel, ou dans lequel, est installé un module électronique selon l'invention et dans lequel le module électronique est installé sur une paroi d'orientation verticale et la carte à circuit imprimé s'étend dans un plan vertical.

Selon d'autres caractéristiques de l'ensemble :
- la carte à circuit imprimé s'étend dans un plan vertical parallèle à au plan général de ladite paroi ;
- le module électronique est logé dans un boîtier qui est installé sur, ou dans, le boîtier du compteur de débit d'un fluide.

### Brève description des figures

[Fig. 1] - la figure 1 est une vue en perspective, de trois-quarts avant, d'un exemple d'un boîtier électronique qui est représenté en association avec un compteur de débit de fluide ;
[Fig. 2] - la figure 2 est une vue en perspective de trois-quarts arrière, du boîtier électronique de la figure 1 ;
[Fig. 3] - la figure 3 est une vue analogue à celle de la figure 1 sur laquelle le boîtier électronique est représenté sans son demi-boîtier avant formant couvercle et contenant un module électronique selon l'invention ;
[Fig. 4] - la figure 4 est une vue en perspective éclatée, de trois-quarts avant, des trois éléments principaux constituant le module électronique représenté à la figure 3 ;
[Fig.5] - la figure 5 est une vue analogue à celle de la figure 4 sur laquelle les trois éléments principaux sont représentés de trois-quarts arrière ;
[Fig. 6] - la figure 6 est une vue avant en élévation du module électronique représenté aux figures 4 et 5 ;
[Fig. 7] - la figure 7 est une vue arrière en élévation du module électronique représenté aux figures 4 et 5 ;
[Fig. 8] - la figure 8 est une vue avant en élévation de la carte à circuit imprimé appartenant au module électronique représenté aux figures 4 et 5 ;
[Fig. 9] - la figure 9 est une vue arrière en élévation de la carte à circuit imprimé représentée à la figure 8 ;
[Fig. 10] - la figure 10 est une vue en coupe, selon la ligne 10-10, du module électronique représenté à la figure 6 ;
[Fig. 11] - la figure 11 est une vue en coupe, selon la ligne 11-11, du module électronique représenté à la figure 6.

### Description détaillée des Figures

Pour la description de l'invention et la compréhension des revendications, à titre non limitatif, on adoptera les orientations verticale, longitudinale et transversale selon le repère V, L, T indiqué aux figures dont les axes longitudinal L et transversal T s'étendent dans un plan horizontal. Par convention, l'axe longitudinal L s'étend d'arrière vers l'avant, tandis que l'axe transversal T s'étend de la gauche vers la droite.

Dans la description qui va suivre, des éléments identiques, similaires ou analogues seront désignés par les mêmes chiffres de référence.

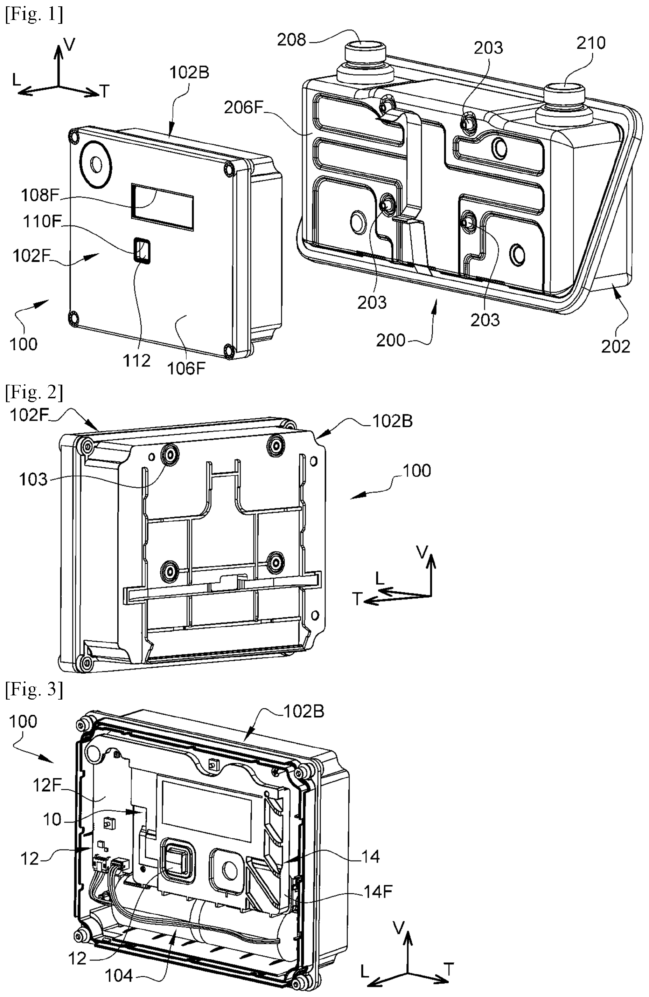

On a représenté aux figures 1 et 2 un boîtier électronique 100 de forme générale parallélépipédique rectangle comportant un demi-boîtier avant 102F formant couvercle et un demi-boîtier arrière 102B.

Comme on peut le voir à la figure 3, le boîtier électronique 100 peut loger différents éléments fonctionnels dont un module électronique 10 selon l'invention et un ensemble 104 de batteries d'alimentation électrique.

La face arrière 106B du demi-boîtier arrière 102B comporte des moyens connus 103 pour sa fixation sur une paroi, qui est ici constituée par une paroi verticale avant 206F appartenant au boitier 202 d'un compteur 200 de débit de fluide. La paroi avant 206F comporte des moyens de fixation 203 complémentaires des moyens 103.

A titre non limitatif, le compteur 200 est ici conçu pour être lui-même fixé sur une paroi d'orientation verticale (en considérant ici la gravité terrestre et l'orientation de la figure) de telle sorte que le boîtier électronique 100 s'étende lui aussi globalement selon une orientation verticale.

Le boîtier 202 du compteur 200 comporte un orifice d'entrée 208 et un orifice de sortie 210 permettant la circulation du fluide à travers le compteur.

Comme on peut le voir à la figure 1, à titre non limitatif, la face avant 106F du demi-boîtier avant 102F comporte ici une fenêtre 108F donnant accès visuellement à un écran d'affichage 42 appartenant au module électronique 10 et une fenêtre 110F permettant d'agir sur un bouton poussoir 112 d'actionnement d'un commutateur électrique 36 appartenant au module électronique 10.

Comme on peut le voir à la figure 3, l'essentiel du volume intérieur du demi-boîtier arrière 102B est occupée par le module électronique 10.

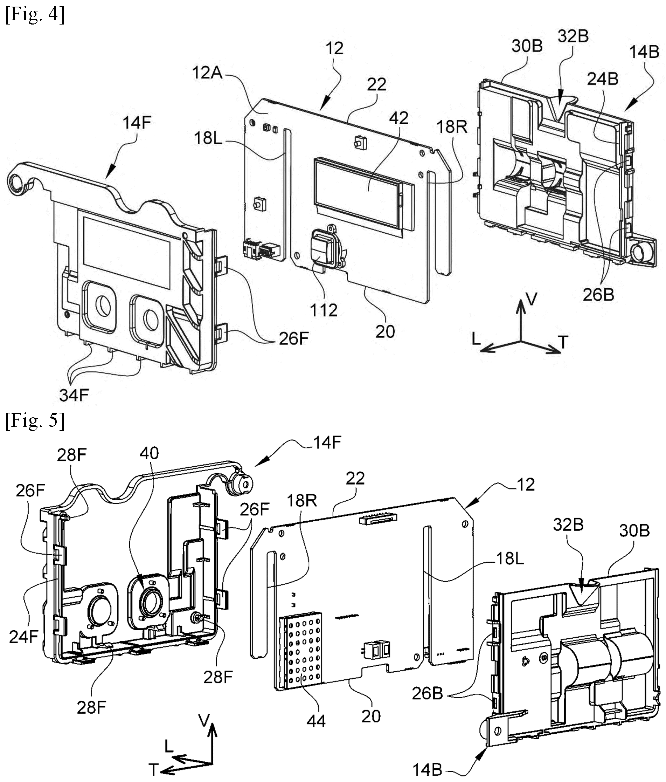

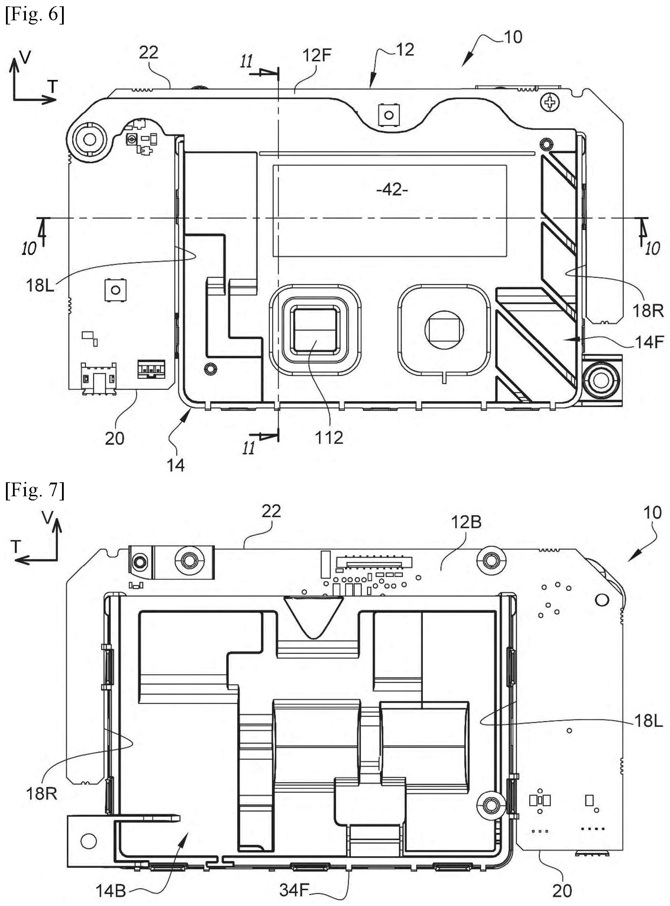

Le module électronique 10 illustré notamment aux figures 4 à 7 présente une forme générale parallélépipédique rectangulaire dont la longueur s'étend horizontalement selon l'axe transversal T, la largeur s'étend verticalement selon l'axe vertical V et dont l'épaisseur s'étend horizontalement selon l'axe longitudinal L.

Le module électronique 10 comporte une carte à circuit imprimé 12, aussi appelée carte électronique ou PCB pour « Printed Circuit Board », qui porte des composants électroniques, électriques et / ou électromécaniques.

Selon l'invention, le module électronique 10 comporte aussi une coque 14 de confinement d'un matériau de protection autour d'une partie des composants portés par la carte à circuit imprimé 12, qui loge en partie la carte à circuit imprimé 12 et qui délimite une cavité interne 16 apte à être remplie au moins partiellement par un matériau de protection des composants, tel qu'un gel de protection coulé à l'intérieur de la cavité interne 16.

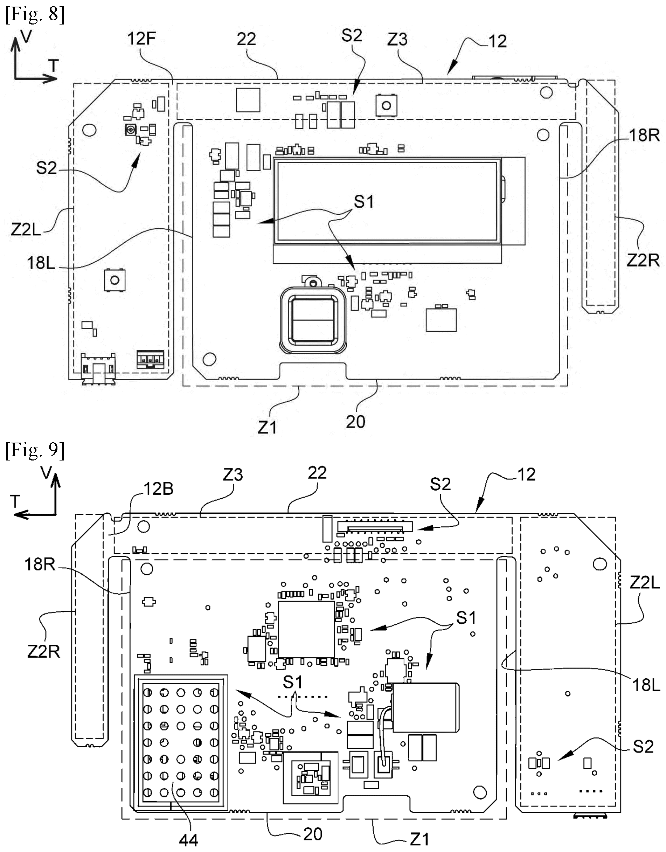

Comme on peut le voir en détails aux figures 8 et 9, la carte à circuit imprimé 12 est de contour général rectangulaire et comporte une face avant 12F et une face arrière opposée 12B.

La carte à circuit imprimé 12 est notamment délimitée par un bord longitudinal inférieur 20 et par un bord supérieur 22.

Plus précisément, en considérant la figure 8, la carte à circuit imprimé 12 comporte ici à titre non limitatif :
- une zone centrale principale Z1 ;
- une zone latérale de gauche Z2L et une zone latérale de droite Z2R qui sont agencées transversalement de part et d'autre de la zone centrale Z1 et dont elles sont séparées par des fentes 18L et 18R qui s'étendent verticalement sur la plus grande partie de la hauteur de la carte à circuit imprimé 12 depuis le bord longitudinal inférieur 20 ;
- et encore une zone supérieure Z3 qui prolonge verticalement vers le haut la zone centrale Z1 et à la quelle, en partie haute, sont reliées les deux zones latérales Z2L et Z2R.

Sur les deux faces opposées avant 12F et arrière 12B de la carte à circuit imprimé 12, la zone centrale principale Z1 porte des composants électroniques, électriques et électromécaniques tels que des transistors, des condensateurs, des circuits intégrés, des commutateurs électriques, des connecteurs, des voyants, des résistances qui, au sens de l'invention, appartiennent à une première série S1 de composants qui sont agencés à l'intérieur de la cavité interne 16 de la coque de confinement 14 et qui sont protégés par le matériau de protection contenu dans la coque de confinement 14.

A titre non limitatif, sur ses deux faces opposées avant et arrière, la zone latérale de droite Z2R est ici dépourvue de composants.

Sur leurs deux faces opposées avant et arrière, la zone latérale de gauche Z2G et la zone supérieure Z3 portent des composants, essentiellement électriques ou électromécaniques tels que des commutateurs électriques, des connecteurs, des voyants, des résistances qui, au sens de l'invention, appartiennent à une deuxième série S2 de composants qui sont agencés à l'extérieur de la coque 14 et qui ne sont pas protégés par le gel de protection des composants appartenant à la première série S1 de composants portés par la carte à circuit imprimé 12.

S'agissant de la coque de confinement 14 et comme on peut le voir en détail notamment aux figures 4, 5, 10 et 11, elle est réalisée en deux parties distinctes qui sont complémentaires et opposées.

Ces deux parties comprennent une partie avant - ou demi-coque avant - 14F et une partie arrière - ou demi-coque arrière -14B.

Chaque partie ou demi-coque est agencée en vis-à vis d'une face associée, respectivement avant 12F et arrière 12B, de la carte à circuit imprimé 12.

Chacune des deux parties 14F, 14B de la coque de confinement 14 est de forme générale parallélépipédique rectangulaire et, dans l'état assemblé de se deux parties 14F et 14B, la coque de confinement 14 entoure la zone centrale principale Z1 qui est ainsi logée dans une cavité interne 16.

Chaque demi-coque comporte une paroi principale verticale faisant face à la carte à circuit imprimé et une paroi latérale périphérique.

En considérant les figures 4 à 7, 10 et 11 et dans l'orientation verticale du module électronique 10 qui y est représentée, la coque de confinement 14 délimite une cavité interne 16 qui est globalement ouverte en partie haute et qui loge la partie centrale principale Z1 de la carte à circuit imprimé 12.

Les deux parties 14F, 14B de la coque de confinement 14 sont assemblées l'une à l'autre selon la direction longitudinale L orthogonale au plan de la carte à circuit imprimé 12 et elles sont fixées l'une à l'autre, ici avantageusement par emboîtement élastique, aussi appelé par « clipsage ».

A cet effet, le bord périphérique arrière 24F de la partie avant 14F comporte ici une série de crochets 26F qui s'étendent longitudinalement en saillie vers l'arrière et dont chacun est apte à coopérer avec un cran complémentaire 26B agencé en vis-à-vis et qui s'étend longitudinalement en saillie vers l'avant depuis le bord périphérique avant 24B de la partie arrière 14B.

La carte à circuit imprimé 12 est ainsi prise en sandwich entre les deux parties 14F, 14B de la coque de confinement 14.

A titre non limitatif, pour l'assemblage du module électronique 10, la carte à circuit imprimé 12 est d'abord fixée à l'intérieur de la partie avant 14F en étant clipsée par des pions et crochets 28F, puis la partie arrière 14B est clipsée sur la partie avant 14F.

A cet effet, les parois latérales assemblées des deux parties 14F et 14B s'étendent à l'intérieur des fentes 18L et 18R de la carte à circuit imprimé 12.

Un tel assemblage permet d'optimiser la durée des opérations d'assemblage sans faire appel à aucun outillage particulier.

De manière préférée, la carte à circuit imprimé 12 avec ses différentes zones est réalisée en une seule pièce. Une telle conception permet de ne pas utiliser des connecteurs inter-cartes. En variante, la carte à circuit imprimé peut être réalisée en plusieurs pièces fixées par exemple à l'intérieur de la première partie avant 14F de la coque de confinement 14.

Après assemblage, c'est ici une face supérieure 30B de la partie arrière 14B qui est ouverte vers le haut pour constituer un orifice de remplissage par coulée, avec une partie centrale 32B évasée formant goulotte de remplissage.

Grâce à une telle conception localisée et de dimensions réduites de l'orifice de remplissage, le matériau de protection est coulé progressivement et sans déperdition précoce de chaleur en lui conservant ainsi sa température optimale de coulée durant le remplissage souhaité de la coque de confinement.

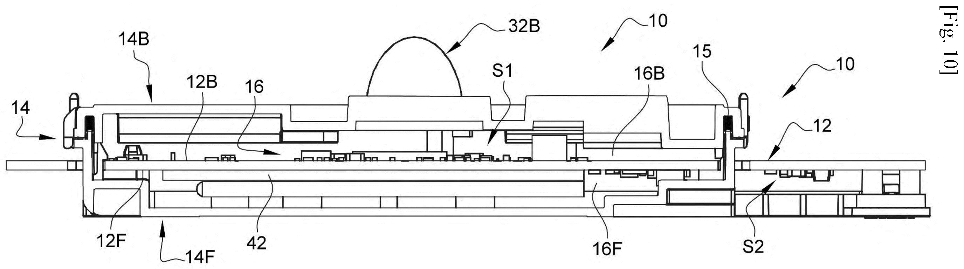

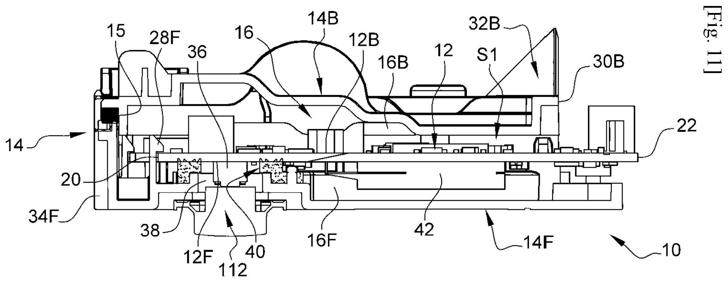

Comme on peut le voir aux figures 10 et 11, la cavité interne 16 de la coque de confinement 14 qui est apte à être remplie de matériau de protection comporte une portion avant 16F délimitée par la partie avant 14F de la coque et par la face avant 12F de la carte à circuit imprimé 12, et une portion arrière 16B délimitée par la partie arrière 14B de la coque de confinement 14 et par la face arrière 12B de la carte à circuit imprimé (12).

L'étanchéité entre les deux parties avant 14F et arrière 14B est assurée au moyen d'un joint 15 dont la fonction consiste à empêcher la fuite du matériau de protection lors de la coulée et durant le temps de polymérisation.

Pour permettre et faciliter un remplissage complet et homogène des deux portions de la cavité interne 16, il est ici prévu un jeu entre le bord inférieur 20 de la carte à circuit imprimé 12 et le fond de la coque de confinement 14.

Ainsi, le matériau de protection coulé dans la portion arrière 16B passe majoritairement en-dessous du bord inférieur 20 pour pénétrer dans la portion avant 16F et remplir cette dernière.

Pour faciliter les opérations de remplissage et les étapes suivantes de stockage du module électronique 10, en partie basse et à l'opposé de la face supérieure 30B de la partie arrière 14B, la coque de confinement 14 comporte une face externe inférieure (Qui s'étend dans un plan horizontal orthogonal au plan de la carte à circuit imprimé 12) d'appui plan du module électronique 10 sur une surface de travail déterminant une orientation verticale du module électronique 10 lors des opérations de coulée de matériau de protection et lors des étapes ultérieures.

Cette face externe inférieure est ici constituée par des nervures 34F de la partie avant 14F de la coque de confinement 14.

De manière à garantir leur bon fonctionnement et / ou de manière à permettre d'y accéder depuis l'extérieur du module électronique, 10 certains composants agencés 10 dans la zone centrale principale Z1 de la carte à circuit imprimé 12 doivent être « isolés » afin de ne pas être noyés dans le matériau de protection.

C'est par exemple le cas du commutateur électrique 36 sur lequel agit le bouton poussoir 112F et qui est agencé sur la face avant 12F de la carte à circuit imprimé 12.

A cet effet, il est prévu des moyens internes de cloisonnement pour délimiter dans la cavité interne 16 - ici dans sa portion avant 16F - un espace 38 dans lequel est agencé le commutateur 36 appartenant à la première série S1 et qui ne contient pas de matériau de protection.

Comme on peut le voir en détail à la figure 11, l'espace 38 est ici délimité par un joint 40 qui est porté par la partie avant 14F de la coque de confinement 14, qui entoure le commutateur 36 et qui est comprimé longitudinalement entre la face interne de la partie avant 14F et une portion en vis-à-vis de la face avant 12F de la carte à circuit imprimé 12.

Comme on peut le voir aux figures 4, 8, 10 et 11, la face avant 12F de la carte à circuit imprimé 12 porte l'écran d'affichage 42 visible à travers la fenêtre 108F du boîtier électronique 100.

Outre la présence de la fenêtre 102F, la coque de confinement 14 est ici réalisée en matériau transparent ou translucide.

Lors des opérations de coulée du matériau de protection et lors des opérations ultérieures, cette transparence du matériau constitutif de la coque de confinement 14 permet de visualiser la présence éventuelle de bulles dans le matériau de protection.

On permet ainsi un contrôle visuel de l'absence de bulles d'air préjudiciables à l'efficacité protectrice du matériau de protection. La coque de confinement 14 est par exemple réalisée en un polymère transparent tel que le polycarbonate ou le poly méthacrylate de méthyle acrylique (PMMA).

Le matériau de protection sous forme de gel apte à être coulé peut être à base d'un gel silicone, de résine époxy ou de polyuréthane transparent.

La forme et les dimensions de la coque de confinement 14 sont déterminées pour épouser au plus près la forme et les dimensions de la carte à circuit imprimé 12 et des composants avec une épaisseur du matériau de protection la plus régulière ou constante possible, ici comprise entre 3mm et 5mm, afin notamment d'optimiser la quantité de matériau de protection. Au niveau de l'écran d'affichage 42, l'épaisseur du matériau de protection est réduite, par exemple à environ 2mm, afin de favoriser la lisibilité des informations affichées.

On a représenté à la figure 9, dans la zone centrale principale Z1 et sur la face arrière 12F de la carte à circuit imprimé 12, un blindage électromagnétique 44 qui est avantageusement percé afin de permettre la pénétration du matériau de protection dans la cavité blindée et aux bulles d'air éventuellement présentes de s'échapper.

Le confinement du matériau de protection à l'intérieur d'une coque rigide facilite l'association éventuelle de la carte à circuit imprimé avec un pavé de matériau amortisseur qui est alors interposé entre une face externe rigide de la coque de confinement et par exemple une paroi d'un boîtier. En effet, on peut ainsi éviter les interférences entre le matériau de protection et le matériau d'amortissement et on facilite la maîtrise de la fonctionnalité d'amortissement.

## Revendications

1. Module électronique (10) comportant :
- une carte à circuit imprimé (12) qui porte des composants électroniques, électriques ou électromécaniques parmi lesquels au moins une première série (S1) de composants qui sont agencés dans une première zone (Z1) de la carte à circuit imprimé (12) et qui, pour les protéger des influences extérieures nocives, sont noyés dans un matériau de protection qui est coulé sur et autour de ces composants,
- et une coque (14) de confinement du matériau de protection autour desdits composants de la première série (S1) :
- - qui loge au moins partiellement la carte à circuit imprimé (12) ;
- - qui délimite une cavité interne (16) remplie au moins partiellement du matériau de protection desdits composants de la première série (S1) ;
- - qui entoure la première zone (Z1) de la carte à circuit imprimé qui est ainsi logée dans une cavité interne (16) ;
- - et qui comporte un orifice (30B, 32B) de coulée du matériau de protection à l'intérieur de la coque (14) de confinement, module électronique dans lequel :
- la carte à circuit imprimé (12) s'étend à l'extérieur de la coque de confinement (14) ;
- une deuxième série (S2) de composants sont agencés dans une deuxième zone (Z2) de la carte à circuit imprimé (12) située à l'extérieur de la coque de confinement (14) ;
- la coque de confinement (14) comporte deux parties complémentaires et opposées assemblées l'une à l'autre, respectivement avant (14F) et arrière (14B), dont chacune est agencée en regard d'une face associée, respectivement avant (12F) et arrière (12B), des deux faces opposées de la carte à circuit imprimé (12) qui est prise en sandwich entre les deux parties (14F, 14B) de la coque de confinement (14),
le module électronique comportant des moyens internes (40) de cloisonnement pour, dans la cavité interne (16) remplie au moins partiellement de matériau de protection, délimiter un espace (38) dans lequel est agencé au moins un composant (36) de la première série (S1) et qui ne contient pas de matériau de protection.

2. Module électronique (10) selon la revendication 1, **caractérisé en ce que** la cavité interne (16) remplie au moins partiellement de matériau de protection comporte une portion avant (16F) délimitée par la partie avant (14F) de la coque et par la face avant (12F) de la carte à circuit imprimé (12), et comporte une portion arrière (16B) délimitée par la partie arrière (14B) de la coque de confinement (14) et par la face arrière (12B) de la carte à circuit imprimé (12).

3. Module électronique (10) selon l'une des revendications 2 ou 3, **caractérisé en ce que** les deux parties opposées (14F, 14B) de la coque de confinement (14) sont assemblées entre elles par emboîtement élastique d'éléments complémentaires.

4. Module électronique (10) selon la revendication précédente, **caractérisé en ce que** les deux parties opposées (14F, 14B) de la coque de confinement (14) sont assemblées entre elles selon une direction orthogonale au plan de la carte à circuit imprimé.

5. Module électronique (10) selon la revendication 1, **caractérisé en ce que** la coque de confinement (14) comporte une face externe basse (34F) d'appui plan du module électronique (10) sur une surface de travail déterminant une orientation verticale du module électronique (10) lors d'une opération de coulée de matériau de protection à l'intérieur de la coque de confinement (14), et **en ce que** ledit orifice de coulée (30B, 32B) est agencé en partie haute de la coque de confinement (14).

6. Module électronique (10) selon la revendication précédente, **caractérisé en ce que** ladite face externe basse (34F) d'appui plan est orthogonale au plan de la carte à circuit imprimé (12).

7. Module électronique (10) selon l'une quelconque des revendications précédentes, **caractérisé en ce que** la coque de confinement (14) est réalisée en un matériau transparent ou translucide permettant de visualiser la présence éventuelle de bulles dans le matériau de protection.

8. Ensemble comportant un compteur (200) de débit d'un fluide, comportant un boîtier (202) sur lequel, ou dans lequel, est installé un module électronique (10) selon l'une quelconque des revendications précédentes, et dans lequel le module électronique (10) est installé sur une paroi d'orientation verticale et la carte à circuit imprimé (12) s'étend dans un plan vertical.

9. Ensemble selon la revendication précédente, **caractérisé en ce que** la carte à circuit imprimé (12) s'étend dans un plan vertical parallèle à au plan général de ladite paroi.

10. Ensemble selon l'une des revendications 11 ou 12, **caractérisé en ce que** le module électronique (10) est logé dans un boîtier (100) qui est installé sur, ou dans, le boîtier (202) du compteur (200) de débit d'un fluide.
